# EUROPÄISCHE PATENTANMELDUNG

(11) **EP 1 761 123 A2**
(43) Veröffentlichungstag der Anmeldung: **07.03.2007**
(21) Anmeldenummer: 06119348.8
(22) Anmeldetag: 23.08.2006
(51) Int. Cl.: H05K 13/04

(54) **Bestückkopf zum Bestücken von Substraten mit elektrischen Bauteilen, Rüstverfahren und Bestückverfahren**

(30) Priorität: 29.08.2005 DE 102005040892
(71) Anmelder: SIEMENS AKTIENGESELLSCHAFT, 80333 München (DE)
(72) Erfinder: Bliem, Thomas, 81379 München (DE); Knoll, Hannes, 80339 München (DE); Rossmann, Thomas, 86919 Utting (DE); Trigiani, Michele, 81373 München (DE)

(57) **Zusammenfassung**

Ein Bestückkopf (7) umfasst einen um eine Drehachse (15) drehbar gelagerten Rotor (16), eine erste Anzahl an Aufnahmen (17), an welchen Greifer lösbar anbringbar sind, wobei sich die Aufnahmen (17) bezüglich der Drehachse (15) paarweise gegenüber stehen, eine zweiten Anzahl an Greifern, welche an den Aufnahmen (17) angebracht sind, Einzelantriebe, mittels welcher die an den Aufnahmen (17) angeordneten Greifer (18) relativ zum Rotor (16) individuell drehbar sind, eine erste Funktionsposition (21), an welcher eine Funktionseinrichtung (22) zur Durchführung eines Arbeitsschrittes angeordnet ist, eine zweite Funktionsposition (23), an welcher die Greifer (18) einen Handhabungsvorgang durchführen, wobei die zweite Funktionsposition (23) der ersten Funktionsposition (21) bezüglich der Drehachse (15) gegenüber liegt, wobei die Greifer (18) zwei durch freie Aufnahmen (17) getrennte Gruppen bilden und die Greifer (18) innerhalb jeder Gruppe an unmittelbar benachbarten Aufnahmen (17) derart angeordnet sind, dass möglichst viele Paare, bestehend aus bezüglich der Drehachse (15) gegenüberliegenden Greifern beider Gruppen, vorgesehen sind.

## Beschreibung

Die Erfindung betrifft einen Bestückkopf zum Bestücken von Substraten mit elektrischen Bauteilen, ein zugehöriges Rüstverfahren, sowie ein Bestückverfahren für ein Bestücksystem mit einem derartigen Bestückkopf.

Aus der Offenlegungsschrift DE-10302802 ist ein Mehrfachbestückkopf mit einem um eine Drehachse drehbar angeordneten Träger bekannt geworden. An dem Träger ist eine Vielzahl von Greifern angeordnet, welche in einer zu der Drehachse winkeligen Aufsetzrichtung bewegbar sind. Jeder Greifer ist mit einem eigenen aktiven Drehantrieb versehen, mittels welchem ein von dem jeweiligen Greifer aufgenommenes Bauteil um eine zur Drehachse des Trägers winkelig angeordnete Greiferachse gedreht werden kann.

Ferner ist bekannt, dass derartige Greifer zum Handhaben von elektrischen Bauteilen an einem Bestückkopf auswechselbar sind. Dadurch ist es möglich, einen Mehrfachbestückkopf mit einer geringeren Anzahl an Greifern auszurüsten, als theoretisch möglich wäre.

Es ist die Aufgabe der vorliegenden Erfindung, einen Bestückkopf, ein zugehöriges Rüstverfahren sowie ein Bestückverfahren für ein Bestücksystem mit einem derartigen Bestückkopf zu liefern, mit welchen Bestückprozesse effizienter durchgeführt werden können.

Diese Aufgabe wird durch den Bestückkopf, das Rüstverfahren und das Bestückverfahren gemäß den unabhängigen Ansprüchen gelöst. Vorteilhafte Ausgestaltungen sind Gegenstand der Unteransprüche.

Ein erfindungsgemäßer Bestückkopf gemäß dem Anspruch 1 weist eine Drehachse und einen um die Drehachse drehbar gelagerten Rotor auf. Eine geradzahlige erste Anzahl an Aufnahmen ist am Rotor kreisförmig um die Drehachse angeordnet. Die Aufnahmen stehen sich bezüglich der Drehachse paarweise gegenüber. An den Aufnahmen können Greifer zur Handhabung elektrischer Bauteile lösbar angebracht werden. Ferner weist der Bestückkopf eine zweite Anzahl an derartigen Greifern auf, welche an den Aufnahmen lösbar angebracht sind, wobei diese zweite Anzahl der Greifer um mindestens zwei kleiner ist als die erste Anzahl der Aufnahmen. Die an den Aufnahmen angeordneten Greifer sind mittels Einzelantriebe des Bestückkopfes relativ zum Rotor individuell drehbar. An einer ersten Funktionsposition am Bestückkopf, zu welcher die Greifer bei Drehung des Rotors nacheinander bewegt werden, ist eine Funktionseinrichtung zur Durchführung eines Arbeitsschrittes angeordnet. Durch Drehung des Rotors sind die Greifer ferner zu einer zweiten Funktionsposition des Bestückkopfes bewegbar, um dort einen Handhabungsvorgang der Bauteile durchzuführen. Die zweite Funktionsposition liegt der ersten Funktionsposition bezüglich der Drehachse gegenüber. Die an den Aufnahmen angeordneten Greifer bilden zwei durch freie Aufnahmen getrennte Gruppen, wobei die Greifer innerhalb jeder Gruppe an unmittelbar benachbarten Aufnahmen derart angeordnet sind, dass möglichst viele Paare, bestehend aus bezüglich der Drehachse gegenüberliegenden Greifer beider Gruppen, am Rotor vorgesehen sind.

Der erfindungsgemäße Bestückkopf weist mehr Aufnahmen auf als Greifer am Bestückkopf angeordnet sind. Die erste Funktionsposition liegt der zweiten Funktionsposition bezüglich der Drehachse gegenüber. Gleichzeitig sind möglichst viele Paare aus bezüglich der Drehachse gegenüber liegenden Greifern beider Gruppen am Rotor vorgesehen. Diese Anordnung bietet zunächst den Vorteil, dass der Handhabungsvorgang eines an der zweiten Funktionsposition angeordneten Greifers der einen Gruppe zeitgleich mit dem Arbeitsschritt der Funktionseinrichtung an einem Greifer der anderen Gruppe oder einem daran gehaltenen Bauteil an der ersten Funktionsposition durchgeführt werden kann. Wie oben erwähnt, sind die Greifer innerhalb jeder Gruppe an unmittelbar benachbarten Aufnahmen angeordnet. Durch diese Anordnung der Greifer am Rotor ist der vom Rotor zurückzulegende Drehwinkel zwischen den Greifern innerhalb einer Gruppe minimiert. Dadurch können Handhabungsvorgänge von Greifern innerhalb einer Gruppe sehr schnell durchgeführt werden. Andererseits sind die Gruppen selbst durch mindestens zwei freie Aufnahmen getrennt sind. Mit geringer werdender zweiter Anzahl an Greifern steigt die Anzahl der die beiden Gruppen trennenden Aufnahmen und damit der Abstand zwischen den beiden Gruppen entlang des Rotors. Größere Drehsprünge des Rotors, welche insbesondere bei einer kleinen zweiten Anzahl an Greifern zur Überwindung der die beiden Gruppen trennenden freien Aufnahmen nötig sind, können jedoch während größerer Verfahrstrecken des Bestückkopfes durchgeführt werden, beispielsweise, wenn der Bestückkopf mittels eines Positioniersystems eines zugeordneten Bestückautomaten verfahrbar ist. Ein derart ausgebildeter Bestückkopf erlaubt bei einem Einsatz in einem Bestücksystem mit einem entsprechenden Positioniersystem und bei einer entsprechenden Koordination der Einzelvorgänge des Bestückprozesses eine effizientere Gestaltung des gesamten Bestückprozesses.

Gemäß einer Ausgestaltung des Bestückkopfes nach Anspruch 2 ist die Funktionseinrichtung eine optische Erfassungseinrichtung, beispielsweise eine Kamera, welche als Arbeitsschritt die an den Geifern gehaltenen Bauteile erfasst. Ferner handelt es sich bei dem Handhabungsvorgang an der zweiten Funktionsposition um die Aufnahme der Bauteile oder die Freigabe bzw. das Absetzen der Bauteile durch den jeweiligen Greifer. Dadurch, dass sich die Greifer beider Gruppen paarweise gegenüberstehen und auch die erste und zweite Funktionsposition bezüglich der Drehachse gegenüberliegend angeordnet sind, kann beispielsweise ein Greifer der einen Gruppe, welcher sich in der ersten Funktionsposition befindet, ein elektrisches Bauteil von einer Zuführeinrichtung aufnehmen oder das Bauteil auf einem Substrat absetzen, während zeitgleich ein Bauteil, welches von dem bezüglich der Drehachse gegenüberliegenden Greifer der anderen Gruppe gehalten wird, durch die Erfassungseinrichtung an der zweiten Funktionsposition erfasst wird.

Gemäß einer Ausgestaltung des Bestückkopfes nach Anspruch 3 ist die zweite Anzahl an Greifern geradzahlig. Dadurch wird gewährleistet, dass jedem Greifer der einen Gruppe immer ein anderer Greifer der anderen Gruppe bezüglich der Drehachse gegenüberliegt. Dies erweist sich deshalb als besonders vorteilhaft, da sich immer dann, wenn sich ein Greifer der einen Gruppe an der ersten Funktionsposition befindet, sich auch gleichzeitig ein Greifer der anderen Gruppe an der zweiten Funktionsposition befindet, wodurch entsprechende Vorgänge zeitgleich durchgeführt werden können. Dadurch wird die Effizienz der an der ersten Funktionsposition und der zweiten Funktionsposition durchgeführten Vorgänge weiter verbessert.

Ein Rüstverfahren gemäß dem unabhängigen Anspruch 4 bezieht sich auf einen Bestückkopf mit den Merkmalen des Anspruchs 1. Bezüglich der Vorteile wird auf die Ausführungen hinsichtlich des Anspruchs 1 verwiesen.

Bezüglich der Vorteile der Ausgestaltungen des Rüstverfahrens nach den Ansprüchen 5 und 6 wird auf die Ausführungen bezüglich der Ansprüche 2 und 3 verwiesen.

Das Bestückverfahren gemäß dem Anspruch 7 bezieht sich auf ein Bestücksystem mit einem Bestückkopf nach einem der Ansprüche 1 bis 3 und einer Positioniereinrichtung, mittels welcher der Bestückkopf zwischen einem Aufnahmebereich des Bestücksystems, in dem elektrische Bauteile durch Zuführeinrichtungen bereitgestellt werden, und einem Bestückbereich des Bestücksystems, in dem die zu bestückenden Substrate bereitgestellt werden, verfahrbar ist. Das Bestückverfahren weist sich dadurch aus, dass, während dem Bewegen des Bestückkopfs zwischen dem Aufnahmebereich und dem Bestückbereich, der Rotor von einem ersten Zustand, in dem sich ein Greifer einer der beiden Gruppen an der zweiten Funktionsposition befindet, in einen zweiten Zustand, in dem sich ein Greifer der jeweils anderen Gruppe an der zweiten Funktionsposition befindet, gedreht wird. Wie schon bezüglich des Anspruchs 1 erwähnt, kann der von dem Rotor zu überwindende Drehwinkel, um von dem ersten Zustand in den zweiten Zustand zu kommen, je nach Größe der zweiten Anzahl an Greifern entsprechend groß sein. Durch das erfindungsgemäße Bestückverfahren wird sichergestellt, dass derartige Rotorsprünge während des Verfahrens des Bestückkopfes zwischen dem Aufnahmebereich und dem Bestückbereich durchgeführt werden. Da bei dem Verfahrvorgang weder Bestückvorgänge noch Aufnahmevorgänge von den Greifern durchgeführt werden können, entsteht für den Bestückprozess kein Zeitverlust. Dadurch wird die Effizienz des gesamten Bestückprozesses weiter erhöht.

Das Bestückverfahren kann gemäß dem Anspruch 8 derart ausgestaltet werden, dass der Rotor während des Bestückens des Substrats im Bestückbereich in einer ersten Drehrichtung gedreht wird, der Rotor beim darauf folgenden Bewegen des Bestückkopfs von dem Bestückbereich zum Aufnahmebereich nicht gedreht wird, und der Rotor während des darauf folgenden Abholens der Bauteile von den Zuführeinrichtungen durch die Greifer in einer der ersten Drehrichtung entgegengesetzten zweiten Drehrichtung gedreht wird. Der Abholvorgang wird daher mit dem Greifer begonnen, welcher das letzte Bauteil auf dem Substrat abgesetzt hat. Folglich muss der Abholvorgang in entgegengesetzter Drehrichtung des Rotors wie bei dem vorhergehenden Bestückvorgang durchgeführt werden. So wird die gesamte Drehtätigkeit des Rotors und damit der Verschleiß der bewegten Teile am Rotor verringert.

Das Bestückverfahren kann gemäß den Ansprüchen 9 und 10 dahingehend ausgestaltet werden, dass, während sich ein Greifer einer der beiden Gruppen in der zweiten Funktionsposition befindet und einen Handhabungsvorgang ausführt, der Arbeitsschritt bezüglich eines Greifers der anderen Gruppe oder eines daran gehaltenen Bauteils von der an der ersten Funktionsposition angeordneten Funktionseinrichtung durchgeführt wird. Handelt es sich bei der Funktionseinrichtung beispielsweise um eine optische Erfassungseinrichtung, wird als Arbeitsschritt das an dem Greifer gehaltene Bauteil erfasst.

Dadurch ist es möglich, zwei Vorgänge, nämlich den Handhabungsvorgang (z.B. Aufnehmen und Absetzen der Bauteile) durch den Greifer der einen Gruppe und den Arbeitschritt bezüglich des Greifers der anderen Gruppe (beispielsweise das Erfassen eines von diesem Greifer gehaltenen Bauteils) zeitgleich und zeitsparend durchzuführen. Auch hierbei wird die Effizienz des Bestückprozesses weiter verbessert.

Im Folgenden wird ein Ausführungsbeispiel der vorliegenden Erfindung mit Bezug auf die beigefügten Figuren näher erläutert. In den Figuren sind:
Figur 1 eine schematische Draufsicht auf ein Bestücksystem mit einem erfindungsgemäßen Bestückkopf,
Figur 2 eine schematische Darstellung eines erfindungsgemäßen Bestückkopfes,
Figur 3 eine schematische Darstellung eines erfindungsgemäßen Bestückverfahrens, und
Figur 4 eine schematische Darstellung eines nicht zur Erfindung gehörenden Bestückkopfes.

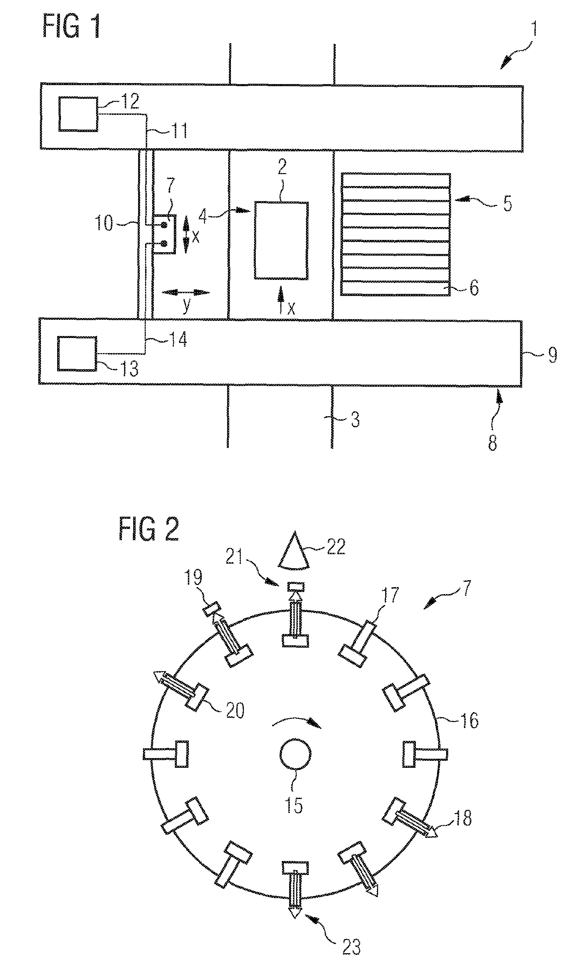

In Figur 1 ist ein Ausführungsbeispiel eines Bestücksystems 1 zum Bestücken von Substraten mit elektrischen Bauteilen schematisch dargestellt. Die zu bestückenden Substrate 2 werden entlang einer Transportstrecke 3 in der Transportrichtung (Pfeil X) zu einen Bestückbereich 4 transportiert, dort mit elektrischen Bauteilen bestückt und anschließend aus dem Bestückbereich 4 wegtransportiert. Seitlich der Transportstrecke 3 befinden sich in einem Aufnahmebereich 5 Zuführeinrichtungen 6, welche die elektrischen Bauteile 19 (siehe Figur 2) bereitstellen. Ein erfindungsgemäßer Bestückkopf 7 ist mittels einer Positioniereinrichtung 8 zwischen dem Aufnahmebereich 5 und dem Bestückbereich 4 verfahrbar angeordnet. Im Aufnahmebereich 5 nimmt der Bestückkopf 7 die von den Zuführeinrichtungen 6 bereitgestellten Bauteile 19 auf, um sie dann auf dem im Bestückbereich 4 angeordneten Substrat 2 abzusetzen. Die Positioniereinrichtung 8 besteht aus zwei portalartigen Querträgern 9, welche sich brückenartig quer über die Transportstrecke 3 erstrecken, sowie einem Längsträger 10, welcher an seinen Enden verschiebbar an den Querträgern 9 gelagert und beispielsweise mittels eines Linearmotors (nicht dargestellt) quer zur Transportrichtung verfahrbar ist. Am Längsträger 10 ist der Bestückkopf 7 mittels eines weiteren Linearmotors (nicht dargestellt) parallel zur Transportrichtung (Pfeil x) bewegbar gelagert.

Wie aus Figur 1 weiterhin hervorgeht, ist der Bestückkopf 7 über pneumatische Leitung 11en mit einer Druckluftversorgung 12 verbunden, welche an einem geeigneten Ort am Bestücksystem 1 angeordnet ist. Eine Regelelektronik 13 für den Bestückkopf 7 ist ebenfalls am Bestücksystem 1 vorgesehen und über entsprechende elektrische Leitungen 14 mit dem Bestückkopf 7 verbunden.

In Figur 2 ist ein Ausführungsbeispiel des erfindungsgemäßen Bestückkopfes 7 dargestellt, wie er in dem Bestücksystem 1 gemäß Figur 1 verwendet wird. Der Bestückkopf 7 weist eine Drehachse 15 und einen um die Drehachse 15 gelagerten Rotor 16 auf, an welchem eine geradzahlige erste Anzahl (im Ausführungsbeispiel beträgt die erste Anzahl 12) an Aufnahmen 17 in gleichmäßigem Winkelabstand kreisförmig um die Drehachse 15 angeordnet sind. Die Aufnahmen 17 stehen sich bezüglich der Drehachse 15 paarweise gegenüber. Die Aufnahmen 17 sind derart ausgebildet, dass daran Greifer 18 zum Handhaben der elektrischen Bauteile 19 lösbar anbringbar sind. Eine zweite Anzahl derartiger Greifern ist lösbar an den Aufnahmen 17 angebracht. Dabei ist die zweite Anzahl an Greifern um mindestens zwei kleiner, als die erste Anzahl an Aufnahmen 17, wobei im Ausführungsbeispiel sechs Greifer 18 am Rotor 16 angebracht sind.

Wie aus Figur 2 ersichtlich ist, bilden die Greifer 18 zwei durch freie (d.h. nicht belegte) Aufnahmen 17 getrennte Gruppen, wobei die Greifer 18 innerhalb einer Gruppe an unmittelbar benachbarten Aufnahmen 17 derart angeordnet sind, dass möglichst viele Paare (im Ausführungsbeispiel 3 Paare), bestehend aus bezüglich der Drehachse 15 gegenüberliegenden Greifern beider Gruppen, am Rotor 16 vorgesehen sind.

Der Bestückkopf 7 weist ferner Einzelantriebe 20 auf, mittels welcher die an den Aufnahmen 17 angeordneten Greifer 18 relativ zum Rotor 16 individuell drehbar sind. Dadurch ist es möglich, ein von einem der Greifer 18 gehaltenes Bauteil 19 in eine gewünschte Winkelposition zu bringen. Bei den Greifern kann es sich beispielsweise um Sauggreifer handeln, welche beim Anbringen an den Aufnahmen 17 jeweils mit der Druckluftversorgung 12 gekoppelt werden, so dass die Spitze der Sauggreifer wahlweise mit Druckluft oder auch mit Vakuum beaufschlagt werden kann. Die Beaufschlagung der Spitze der Greifer 18 mit Vakuum ermöglicht die Aufnahme 17 und das Halten elektrischer Bauteile 19, wogegen die Beaufschlagung mit Druckluft ein Abgeben des Bauteiles, beispielsweise auf dem Substrat 2, ermöglicht.

Am Bestückkopf 7 existiert eine erste Funktionsposition 21, an welcher eine Funktionseinrichtung 22, hier eine optische Erfassungseinrichtung 22 zum Erfassen der an den Greifern 18 gehaltenen Bauteile 19, angeordnet ist. Dabei kann es sich beispielsweise um eine Bauteilkamera handeln, welche als Arbeitsschritt die Winkelposition des Bauteils bestimmt. Im Anschluss an diese Bestimmung der Winkelposition können die Bauteile 19 anhand der Einzelantriebe 20 vor dem Aufsetzen auf dem Substrat 2 in eine gewünschte Winkelposition gedreht werden. Die Greifer 18 werden bei Drehung des Rotors 16 nacheinander zu der ersten Funktionsposition 21 bewegt.

An einer zweiten Funktionsposition 23 des Bestückkopfes 7 sind Handhabungsvorgänge, wie beispielsweise das Aufsetzen der Bauteile 19 auf dem Substrat 2 oder das Aufnehmen der Bauteile 19 von einer der Zuführeinrichtungen 6, durch die Greifer 18 durchführbar. Die zweite Funktionsposition 23 liegt der ersten Funktionsposition 21 bezüglich der Drehachse 15 gegenüber. Zur Durchführung der Handhabungsvorgänge sind die Greifer 18 bezüglich des Rotors 16 in einer radialen Richtung verschiebbar gelagert. Durch einen entsprechenden, nicht näher beschriebenen Antriebsmechanismus werden die Greifer 18 beispielsweise beim Absetzen von Bauteilen auf einem Substrat 2 in radialer Richtung auf das Substrat 2 zu bewegt und anschließend in die Ausgangsposition zurückbewegt.

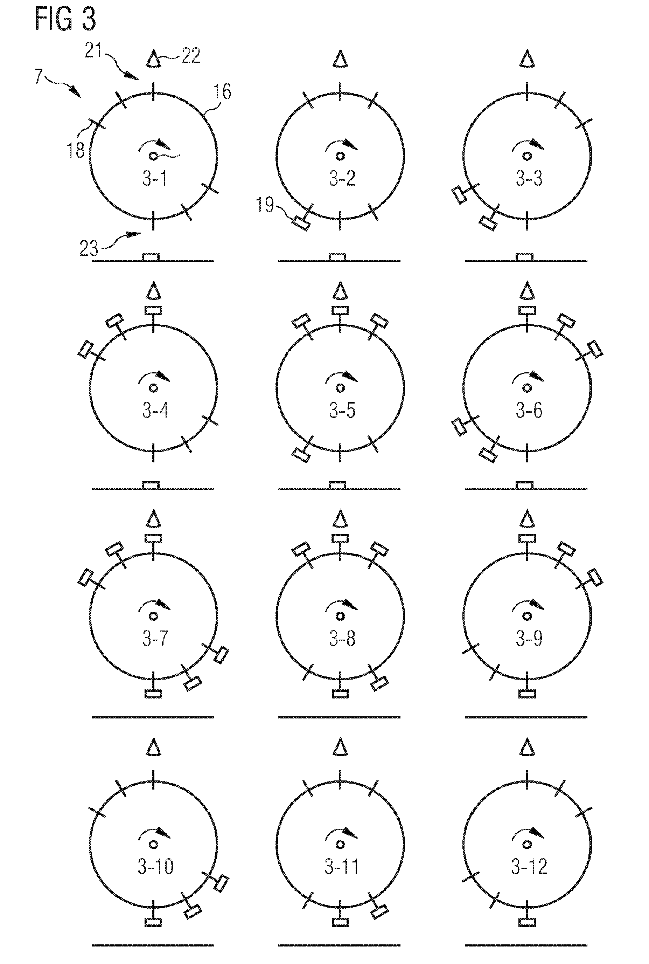

Anhand der Figur 3 wird ein durch das oben beschriebene Bestücksystem 1 durchgeführte Bestückverfahren und die sich daraus ergebenen Vorteile näher beschrieben. Der Aufbau des in Figur 3 dargestellten Bestückkopfs 7 ist identisch mit dem Aufbau des anhand von Figur 2 beschriebenen Bestückkopf 7. Jedoch ist der Bestückkopf 7 des Figur 3 sehr schematisch dargestellt, wobei auf Bestandteile, welche nicht zur Erklärung des Verfahrens notwendig sind, verzichtet wurden. So sind die am Rotor 16 angeordneten Greifer 18 als einfache Striche dargestellt, wobei auf die Darstellung der Aufnahmen 17 und der Einzelantriebe 20 verzichtet wurde. Ferner ist darauf hinzuweisen, dass im Folgenden ein Verfahrvorgang des Bestückkopfes 7 zwischen dem Bestückbereich 4 und dem Aufnahmebereich 5 mittels der Positioniereinrichtung 8 als Positioniersprung bezeichnet wird.

Das in Figur 3 dargestellte Bestückverfahren umfasst die zwölf Schritte 3-1 bis 3-12. Dabei beziehen sich die Schritte 3-1 bis 3-6 auf den Abholvorgang, bei welchem im Aufnahmebereich 5 des Bestücksystems 1 Bauteile 19 durch die am Rotor 16 angeordneten Greifer 18 des Bestückkopfes 7 aufgenommen werden. Die Schritte 3-7 bis 3-12 betreffen den eigentlichen Bestückvorgang, bei welchem die elektrischen Bauteile 19 von den Greifern auf dem Substrat 2 im Bestückbereich 4 abgesetzt werden. Zwischen dem Verfahrensschritt 3-6 und 3-7 findet demnach ein Positioniersprung statt, bei dem der Bestückkopf 7 von dem Aufnahmebereich 5 in den Bestückbereich 4 verfahren wird.

In den Schritten 3-1 bis 3-3 werden die auf der unteren Hälfte des Rotors 16 angeordneten Greifer 18, welche eine Gruppe von Greifern am Rotor 16 bildet, nacheinander in die zweite Funktionsposition 23 des Bestückkopfes 7 gedreht, wobei derjenige Greifer 18, welcher sich gerade in der zweiten Funktionsposition 23 befindet, radial vom Rotor 16 in Richtung auf ein von einer Zuführeinrichtung bereitgestelltes Bauteil 19 zu bewegt wird und dieses aufnimmt. Nach der Aufnahme 17 wird der jeweilige Greifer 18 wieder in die Ausgangslage am Rotor 16 zurückbewegt, woraufhin der Rotor 16 den nächsten Greifer 18 in die zweite Funktionsposition 23 dreht.

Die Greifer 18 innerhalb einer Gruppe sind um jeweils 30° versetzt am Rotor 16 angeordnet. Daraus folgt, dass ausgehend vom Schritt 3-1, bei dem der in Drehrichtung (Pfeil) erste Greifer 18 der einen Gruppe ein Bauteil 19 aufnimmt, bis zum Schritt 3-3, bei dem der in Drehrichtung dritte und letzte Greifer 18 dieser Gruppe in der zweiten Funktionsposition 23 ein Bauteil 19 aufnimmt, der Rotor 16 um insgesamt 60° gedreht werden muss. Beim Übergang vom Schritt 3-3 zu Schritt 3-4 wird der Rotor 16 in Drehrichtung soweit gedreht, dass der in Drehrichtung erste Greifer 18 der anderen Gruppe an der zweiten Funktionsposition 23 positioniert ist. Wie anhand der Figur 3 in Verbindung mit Figur 2 klar wird, muss der Rotor 16 dabei um weitere 120° gedreht werden.

Im Schritt 3-4 befindet sich der in Drehrichtung erste Greifer 18 der einen Gruppe mit dem daran gehaltenen Bauteil 19 an der ersten Funktionsposition 21 des Bestückkopfes 7. Die Funktionseinrichtung 22 kann dabei die Winkellage des Bauteils erfassen. Zeitgleich kann der bezüglich der Drehachse 15 gegenüberliegend angeordnete erste Greifer 18 der anderen Gruppe, welcher sich in der zweiten Funktionsposition 23 befindet, ein Bauteil 19 von einer Zuführeinrichtung aufnehmen. In den nachfolgenden Schritten 3-5 und 3-6 werden die in Drehrichtung nachfolgenden Greifer 18 der einen Gruppe in die erste Funktionsposition 21 bewegt, so dass die daran gehaltenen Bauteile 19 durch die Erfassungseinrichtung 22 erfasst werden. Gleichzeitig nehmen die in Drehrichtung nachfolgenden Greifer 18 der anderen Gruppe Bauteile 19 von den Zuführeinrichtungen 6 auf. Auch hier wird deutlich, dass der Rotor 16 vom Schritt 3-4 nach Schritt 3-6 um weitere 60° gedreht werden muss.

Nach Abschluss des Aufnahmevorganges in Schritt 3-6 haben alle am Rotor 16 angeordneten Greifer 18 ein Bauteil 19 aufgenommen, wobei die an den Greifern der ersten Gruppe angeordneten Bauteile 19 bereits durch die Erfassungseinrichtung 22 erfasst wurden. Diese Bauteile 19 werden dann durch die Einzelantriebe 20 des Bestückkopfes 7 in die gewünschte endgültige Winkelposition, welche zum Bestücken notwendig ist, gedreht.

Beim Übergang 3-6 nach 3-7 findet ein Positioniersprung des Bestückkopfes 7 vom Aufnahmebereich 5 in den Bestückbereich 4 statt. Während dieses Positioniersprungs wird der Rotor 16 um weitere 120° gedreht, so dass der erste Greifer 18 der einen Gruppe bei Ankunft im Bestückbereich 4 die zweite Funktionsposition 23 eingenommen hat. Da die an den Greifern der einen Gruppe angeordneten Bauteile 19 bereits ihre endgültige Winkellage eingenommen haben, kann das in Drehrichtung am ersten Greifer 18 der einen Gruppe gehaltene Bauteil 19 durch Absenken des Greifers in Richtung auf das zu bestückende Substrat 2 in Schritt 3-7 auf dem Substrat 2 abgesetzt werden. Gleichzeitig wird das Bauteil 19, welches sich an dem bezüglich der Drehachse 15 gegenüberliegenden Greifer 18 der anderen Gruppe befindet, durch die Erfassungseinrichtung 22 erfasst. Bei den Übergängen von Schritt 3-7 nach Schritt 3-8 und von Schritt 3-8 nach Schritt 3-9 wird der Rotor 16 jeweils um 30° weiter gedreht. Dabei werden in den Schritten 3-8 und 3-9 jeweils die an den nachfolgenden Greifern der einen Gruppe angeordneten Bauteile 19 auf dem Substrat 2 abgesetzt, wogegen gleichzeitig die an den nachfolgenden Greifern der anderen Gruppe angeordneten Bauteile 19 von der Erfassungseinrichtung 22 erfasst werden.

Beim Übergang vom Schritt 3-9 nach 3-10 wird der Rotor 16 um weitere 120° gedreht. Schließlich befindet sich der in Drehrichtung erste Greifer 18 der anderen Gruppe an der zweiten Funktionsposition 23. Da die an den Greifern der anderen Gruppe befindlichen Bauteile 19 bereits in der erforderlichen endgültigen Winkellage sind, kann der sich in der zweiten Funktionsposition 23 befindliche Greifer 18 der anderen Gruppe das an ihm gehaltene Bauteil 19 auf dem Substrat 2 absetzen. In den nachfolgenden Schritten 3-11 und 3-12 werden auch die Bauteile 19, welche an den nachfolgenden Greifern der anderen Gruppe anhaften, auf das Substrat 2 abgesetzt. Beim Übergang zwischen den Schritten wird der Rotor 16 jeweils um weitere 30° gedreht.

Anschließend an Schritt 3-12 befindet sich kein Bauteil 19 mehr am Bestückkopf 7. Der Bestückkopf 7 muss deshalb zur Aufnahme 17 weiterer Bauteile 19 wieder in den Aufnahmebereich 5 verfahren werden. Deshalb ist ein weiterer Positioniersprung notwendig. Ist der Bestückkopf 7 dann wieder in dem Aufnahmebereich 5 positioniert, kann das Verfahren bei Schritt 3-1 von neuem begonnen werden. Bei dem Positioniersprung von Schritt 3-12 nach 3-1 muss der Rotor 16 um weitere 120° gedreht werden, so dass der in Drehrichtung erste Greifer 18 der einen Gruppe wieder in der zweiten Funktionsposition 23 angeordnet ist.

Wie aus dem obigen Ausführungen deutlich wird, muss der Rotor 16 zur Durchführung eines vollständigen Zyklus, d.h. einen vollständigen Durchlauf der Schritte 3-1 bis 3-12 und zurück nach 3-1, zwei vollständige Umdrehungen durchführen, d.h. um 720° gedreht werden. Dabei können durch die erfindungsgemäße Ausgestaltung des Bestückkopfes 7 mit der erfindungsgemäßen Rüstung der Greifer 18 am Bestückkopf 7 zwei Drehungen zu je 120° während der Positioniersprünge beim Übergang zwischen den Schritten 3-6 und 3-7 bzw. 3-12 und 3-1 durchgeführt werden. Da diese Positioniersprünge auf jeden Fall durchgeführt werden müssen, haben diese beiden Drehungen zu je 120° keinen verzögernden Effekt auf den Bestückprozess. Dadurch kann die Effizienz des Bestückprozesses erheblich gesteigert werden.

Wie aus obiger Darstellung hervorgeht, wird der Rotor 16 während des Bestückens des Substrats 2 im Bestückbereich 4 (Schritte 3-7 bis 3-12 in Fig. 3) in einer ersten Drehrichtung (in Fig. 3 durch einen Pfeil dargestellt) gedreht. Alternativ zur obigen Darstellung wird der Rotor 16, nachdem der letzte Greifer 18 das von ihm gehaltene Bauteil 19 auf dem Substrat 2 abgesetzt hat und während des darauf folgenden Bewegens des Bestückkopfs 7 von dem Bestückbereich 4 zum Aufnahmebereich 5 (Schritt 3-12 nach 3-1 in Fig. 3), nicht gedreht. Dadurch kann der darauf folgende Abholvorgang im Aufnahmebereich 5 mit dem Geifer 18 begonnen werden, welcher das letzte Bauteil 19 auf dem Substrat 2 im Bestückbereich 4 abgesetzt hat. Aufgrund der Anordnung der Greifer 18 wird der Rotor 16 dann während des Abholvorgangs und während des darauf folgenden Bestückvorgangs in einer der ersten Drehrichtung entgegengesetzten zweiten Drehrichtung gedreht wird. Dadurch wird die Drehtätigkeit des Rotors 16 und der Verschleiß der bewegten Teile weiter vermindert.

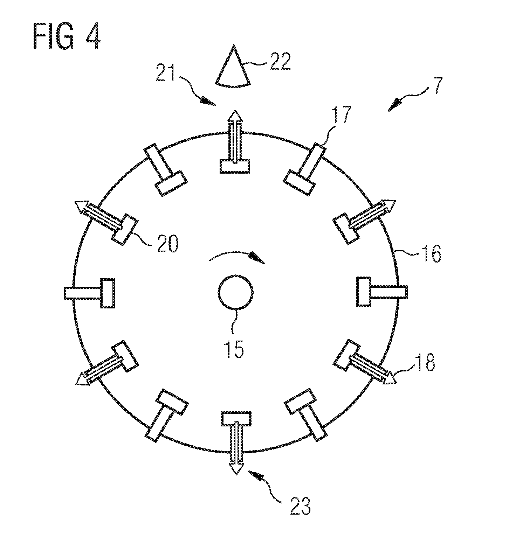

In Figur 4 ist zum Vergleich eine nicht zur Erfindung gehörende Anordnung der Greifer 18 an einen Bestückkopf 7 dargestellt. Hierbei handelt es sich ebenfalls um einen Bestückkopf 7 mit 12 Aufnahmen 17 für je einen Greifer 18, wobei nur 6 Greifer 18 tatsächlich am Bestückkopf 7 angeordnet sind. Die Greifer 18 sind dabei nicht in Gruppen, sondern gleichmäßig mit einem Zwischenabstand von je einer leeren Aufnahme 17, was einen Abstand von 60° entspricht, angeordnet. Bei einer Durchführung eines kompletten Zyklus analog zu den Schritten 3-1 bis 3-12 und zurück nach 3-1 ist festzustellen, dass der Rotor 16 während eines Positioniersprungs lediglich um 60° gedreht werden kann. Insgesamt muss der Rotor 16 auch hier zur Durchführung des kompletten Bestückzyklus um zwei komplette Drehungen, d. h. 720° gedreht werden, wobei in den beiden Positioniersprüngen der Rotor 16 um insgesamt 120° gedreht werden kann. Dies bedeutet weiterhin, dass bei Verwendung eines derartigen Bestückkopfes 7 ein kompletter Bestückzyklus deutlich länger dauert.

Im Ausführungsbeispiel der vorliegenden Erfindung gemäß den Figuren 1 bis 3 sind lediglich 6 Greifer 18 am Bestückkopf 7 angeordnet. Der Erfindungsgedanke ist jedoch allgemein auf einen Bestückkopf 7 mit einer geradzahligen ersten Anzahl an Aufnahmen 17 und einer am Bestückkopf 7 angebrachten zweiten Anzahl an Greifern analog übertragbar, wobei die zweite Anzahl um mindestens zwei kleiner ist als die erste Anzahl der Aufnahmen 17.

Im Ausführungsbeispiel handelt es sich bei der Funktionseinrichtung um eine Erfassungseinrichtung bzw. eine Kamera zum Erkennen und Vermessen der Bauteile. Bei der Funktionseinrichtung kann es sich jedoch um jede andere Einrichtung handeln, welche einen Arbeitsschritt an einem Greifer oder einem daran gekoppelten Bauteil durchführt, wie beispielsweise eine Einrichtung zur Überprüfung der Funktionsfähigkeit der Bauteile oder der Greifer selbst.

### Bezugszeichenliste

- 1: Bestücksystem
- 2: Substrat
- 3: Transportstrecke
- 4: Bestückbereich
- 5: Aufnahmebereich
- 6: Zuführeinrichtung
- 7: Bestückkopf
- 8: Positioniereinrichtung
- 9: Querträger
- 10: Längsträger
- 11: Pneumatische Leitung
- 12: Druckluftversorgung
- 13: Regelelektronik
- 14: Elektrische Leitung
- 15: Drehachse
- 16: Rotor
- 17: Aufnahmen
- 18: Greifer
- 19: Bauteile
- 20: Einzelantrieb
- 21: erste Funktionsposition
- 22: Erfassungseinrichtung
- 23: zweite Funktionsposition

## Patentansprüche

1. Bestückkopf (7) zum Bestücken von Substraten mit elektrischen Bauteilen, mit
- einer Drehachse (15),
- einem um die Drehachse (15) drehbar gelagerten Rotor (16),
- einer geradzahligen ersten Anzahl an Aufnahmen (17), an welchen Greifer (18) zum Handhaben der Bauteile (19) lösbar anbringbar sind, wobei die Aufnahmen (17) am Rotor (16) kreisförmig um die Drehachse (15) angeordnet sind und sich bezüglich der Drehachse (15) paarweise gegenüber stehen,
- einer zweiten Anzahl an Greifern, welche an den Aufnahmen (17) lösbar angebracht sind, wobei die zweite Anzahl der Greifer (18) um mindestens zwei kleiner ist als die erste Anzahl der Aufnahmen (17),
- Einzelantrieben, mittels welcher die an den Aufnahmen (17) angeordneten Greifer (18) relativ zum Rotor (16) individuell drehbar sind,
- einer ersten Funktionsposition (21), zu welcher die Greifer (18) bei Drehung des Rotors (16) nacheinander bewegt werden und an welcher eine Funktionseinrichtung (22) zur Durchführung eines Arbeitsschrittes angeordnet ist,
- einer zweiten Funktionsposition (23), zu welcher die Greifer (18) bei Drehung des Rotors (16) nacheinander bewegt werden, um dort einen Handhabungsvorgang durchzuführen, wobei die zweite Funktionsposition (23) der ersten Funktionsposition (21) bezüglich der Drehachse (15) gegenüber liegt,
wobei die Greifer (18) zwei durch freie Aufnahmen (17) getrennte Gruppen bilden und die Greifer (18) innerhalb jeder Gruppe an unmittelbar benachbarten Aufnahmen (17) derart angeordnet sind, dass möglichst viele Paare, bestehend aus bezüglich der Drehachse (15) gegenüberliegenden Greifern beider Gruppen, am Rotor (16) vorgesehen sind.

2. Bestückkopf nach Anspruch 1, wobei
- die Funktionseinrichtung (22) eine optische Erfassungseinrichtung (22) und der Arbeitsschritt das Erfassen von an den Greifern (18) gehaltenen Bauteilen (19) ist, und
- es sich bei der Handhabung an der zweiten Funktionsposition (23) um die Aufnahme der Bauteile (19) oder der Freigabe der Bauteile durch die Greifer (18) handelt.

3. Bestückkopf (7) nach einem der Ansprüche 1 bis 2, wobei die zweite Anzahl an Greifer (18) geradzahlig ist.

4. Rüstverfahren für einen Bestückkopf (7) zum Bestücken von Substraten mit elektrischen Bauteilen mit
- einer Drehachse (15),
- einem um die Drehachse (15) drehbar gelagerten Rotor (16),
- geradzahligen ersten Anzahl an Aufnahmen (17), an welchen Greifer (18) zum Handhaben der Bauteile (19) lösbar anbringbar sind, wobei die Aufnahmen (17) am Rotor (16) kreisförmig um die Drehachse (15) angeordnet sind und sich bezüglich der Drehachse (15) paarweise gegenüber stehen,
- Einzelantrieben, mittels welcher die an den Aufnahmen (17) angeordneten Greifer (18) relativ zum Rotor (16) individuell drehbar sind,
- einer ersten Funktionsposition (21), zu welcher die Greifer (18) bei Drehung des Rotors (16) nacheinander bewegt werden und an welcher eine Funktionseinrichtung (22) zur Durchführung eines Arbeitsschrittes angeordnet ist,
- einer zweiten Funktionsposition (23), zu welcher die Greifer (18) bei Drehung des Rotors (16) nacheinander bewegt werden, um dort einen Handhabungsvorgang durchzuführen, wobei die zweite Funktionsposition (23) der ersten Funktionsposition (21) bezüglich der Drehachse (15) gegenüber liegt,
wobei eine zweite Anzahl an Greifer (18) derart an den Aufnahmen (17) lösbar angeordnet wird, dass die Greifer (18) zwei durch freie Aufnahmen (17) getrennte Gruppen bilden und die Greifer (18) innerhalb jeder Gruppe an unmittelbar benachbarten Aufnahmen (17) angeordnet sind, und dass möglichst viele Paare, bestehend aus bezüglich der Drehachse (15) gegenüberliegenden Greifer (18) beider Gruppen, am Rotor (16) vorgesehen sind, und wobei die zweite Anzahl der Greifer (18) um mindestens zwei kleiner ist als die erste Anzahl der Aufnahmen (17).

5. Rüstverfahren nach Anspruch 4, wobei
- die Funktionseinrichtung (22) eine optische Erfassungseinrichtung (22) und der Arbeitsschritt das Erfassen von an den Greifern (18) gehaltenen Bauteilen (19) ist, und
- es sich bei der Handhabung an der zweiten Funktionsposition (23) um die Aufnahme der Bauteile (19) oder der Freigabe der Bauteile durch die Greifer (18) handelt.

6. Rüstverfahren nach einem der Ansprüche 4 bis 5, wobei die zweite Anzahl der Greifer (18) geradzahlig ist.

7. Bestückverfahren für ein Bestücksystem (1) mit einem Bestückkopf (7) nach einem der Ansprüche 1 bis 3, wobei während dem Bewegen des Bestückkopfs (7) mittels einer Positioniereinrichtung (8) zwischen einem Aufnahmebereich (5) des Bestücksystems (1), in dem die elektrischen Bauteile (19) durch Zuführeinrichtungen (6) zugeführt werden, und einem Bestückbereich (4) des Bestücksystems (1), in dem die zu bestückenden Substrate (2) bereitgestellt werden, der Rotor (16) von einem ersten Zustand, in dem sich ein Greifer (18) einer der beiden Gruppe an der zweiten Funktionsposition (23) befindet, in einen zweiten Zustand, in dem sich ein Greifer (18) der jeweils anderen Gruppe an der zweiten Funktionsposition (23) befindet, gedreht wird.

8. Bestückverfahren nach Anspruch 7, wobei der Rotor (16) während des Bestückens des Substrats (2) im Bestückbereich (4) in einer ersten Drehrichtung gedreht wird, der Rotor (16) beim darauf folgenden Bewegen des Bestückkopfs (7) von dem Bestückbereich (4) zum Aufnahmebereich (5) nicht gedreht wird, und der Rotor (16) während des darauf folgenden Abholens der Bauteile (19) von den Zuführeinrichtungen (6) durch die Greifer (18) in einer der ersten Drehrichtung entgegengesetzten zweiten Drehrichtung gedreht wird.

9. Bestückverfahren nach einem der Ansprüche 7 bis 8, wobei, während sich ein Greifer (18) einer der beiden Gruppen in der zweiten Funktionsposition (23) befindet und einen Handhabungsvorgang ausführt, an der ersten Funktionsposition (21) der Arbeitsschritt bezüglich eines Greifers (18) der anderen Gruppe mittels der Funktionseinrichtung (23) durchgeführt wird.

10. Bestückverfahren nach Anspruch 9, wobei es sich bei dem Handhabungsvorgang an der zweiten Funktionsposition (23) um die Aufnahme der Bauteile (19) oder der Freigabe der Bauteile durch die Greifer (18) handelt und die Funktionseinrichtung (22) eine optische Erfassungseinrichtung (22) und der Arbeitsschritt das Erfassen von an den Greifern (18) gehaltenen Bauteilen (19) ist.
